# EUROPEAN PATENT SPECIFICATION

(11) **EP 0 593 155 B1**
(45) Date of publication and mention of the grant of the patent: **23.07.1997**
(21) Application number: 93306479.2
(22) Date of filing: 17.08.1993
(51) Int. Cl.: H05K 3/30, H05K 3/32

(54) **Parts installation structure and method of manufacturing parts installation structure**
Installierungsstruktur für Bauteile und Verfahren zur Herstellung einer Installierungsstruktur für Bauteile
Structure d'installation pour composants et procédé de fabrication d'une structure d'installation pour composants

(30) Priority: 17.08.1992 JP 240034/92
(43) Date of publication of application: 20.04.1994
(73) Proprietor: MINEBEA CO.,LTD., Kitasaku-gun Nagano-ken (JP)
(72) Inventor: Shiota, Naohiro, Kohhoku-ku, Yokohama-shi, Kanagawa (JP); Obara, Rikuro, Kitasaku-gun, Nagano (JP)
(74) Representative: Jackson, Peter Arthur

(56) References cited:
- US-A- 4 774 634
- US-A- 4 999 136
- TOUTE L'ELECTRONIQUE no. 508 , November 1985 , PARIS FR pages 62 - 67 F. LAMBERT 'Techniques de montage des composants en surface'

## Description

The present invention relates to a membrane switch structure and a manufacturing method therefor.

In recent years, many electronic devices have been developed, and a printed-circuit board is indispensable to such electronic devices.

When printed-circuit boards first appeared on the market, terminals of electronic parts such as semiconductor parts were inserted in small holes opening to the wiring pattern of the printed wiring board. Then the printed-circuit board was dipped in a dip-tank of solder. The terminal and the wiring pattern were soldered and the electronic circuit was thus assembled. However, quite recently the electronic parts have become miniaturized as well. The method of installing electronic parts to the printed-circuit board has changed. For instance, a paste solder is spread on a fixed part of the wiring pattern of the printed-circuit board, and the terminals of electronic parts such as transistors are brought into contact with the board. Then the paste solder is melted by infrared heating etc, and soldering is achieved between the terminals of electronic parts and the printed circuit.

The membrane switch has come to be used as a switch for keyboards used for personal-computers etc. in recent years, for miniaturizing the keyboard. Moreover, the electronic parts such as large-scale IC and luminescence elements are to be mounted on the substrate of the membrane switch of the keyboard.

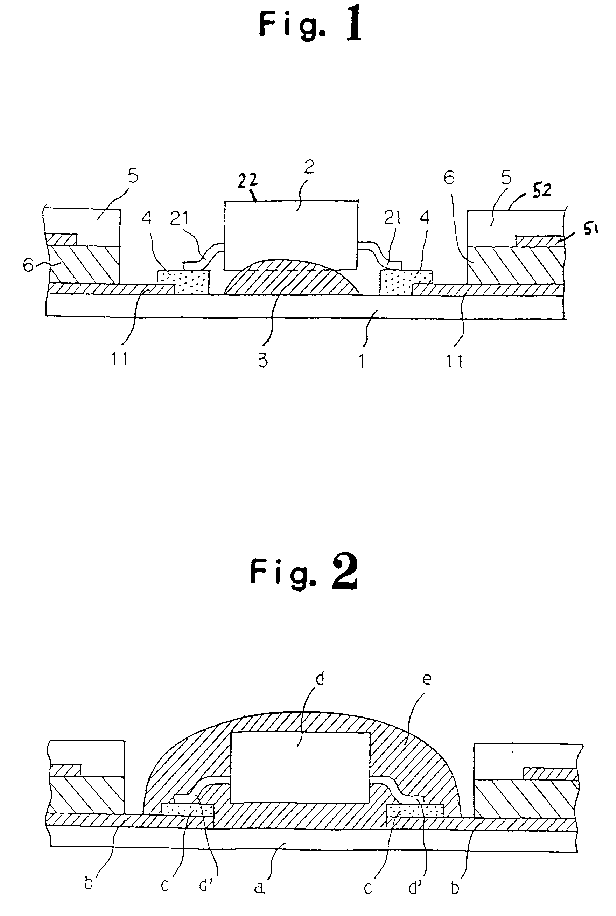

FIG. 2 is an explanatory drawing of one prior example of an electronic part (d) mounted on the base of such a membrane switch. The lead (d') of the electronic part, e.g. a chip diode is fixed by a conductive adhesive (c) on a membrane switch sheet (a) on which is printed a wiring pattern (b). A sealing member (e) of a UV stiffening material covers on the membrane switch sheet (a) and the chip diode (d).

In the mounting of the part as mentioned above, the chip diode (d) is held onto the membrane switch sheet (a) and is covered by the sealing member (e). Therefore, the entire thickness becomes large and it is unsuitable for a thin keyboard.

Moreover, the whole of the printed wiring pattern (b) and the electronic part are covered by the sealing member (e). Therefore, when an area of the printed wiring pattern (b) and the electronic parts are wide, a lot of sealing material is needed. The UV ray does not reach the lower side of electronic parts (d), and the sealing material is not properly cured by the UV ray. Therefore the membrane switch sheets have to be inserted in a furnace for the stiffening the sealing materials.

In addition, when a large force is applied between the membrane switch sheet (a) and the sealing member (e) or electronic part (d), the wide area of the printed circuits on the membrane switch sheet (a) may be damaged, and a peeling off may occur between the membrane switch sheet (a) and the sealing member (e) or electronic part (d).

In view of the aforesaid drawback of the conventional installation structure and its manufacturing method, it is an object of the present invention to provide a thin parts installation structure and corresponding manufacturing method.

US-A-4774634 and -4999136 disclose electronic parts mounted on circuit boards by conductive and non-conductive adhesives, for providing electrical connection to the board, and for mechanically mounting the part on the board, respectively.

According to the present invention, a membrane switch structure having an electronic part fixed to a printed circuit comprises a lower membrane switch sheet, an upper membrane switch sheet overlying the lower membrane switch sheet but not the electronic part; a spacer between the lower and upper membrane switch sheets; and a printed circuit on that surface of each of the lower and upper membrane switch sheets facing the other sheet, facing parts of the printed circuits providing electric contact points for the switch; the electronic part being fixed onto the upper surface of the lower membrane switch sheet by means of an interposed painted layer of non-conductive adhesive, and leads of the electronic part being connected by means of a conductive adhesive to the printed circuit on the lower membrane switch sheet whereby the upper surface of the electronic part is at substantially the same level as the upper surface of the upper membrane switch sheet.

The invention also includes a method of manufacturing a membrane switch structure having an electronic part fixed to a printed circuit, the method comprising the steps of forming a printed circuit on a lower membrane switch sheet; painting a non-conductive adhesive on the lower membrane switch sheet where the electronic part is to be installed; applying a conductive adhesive to a lead of the electronic part and to the printed circuit and putting the electronic part on the lower membrane switch sheet where the part is to be installed, with the lead in contact with the printed circuit and the bottom of the electronic part in contact with the non-conductive adhesive; stiffening the non-conductive and conductive adhesives by means of heat whereby the electronic part is installed on the lower membrane switch sheet with its lead connected to the printed circuit; providing a spacer on the lower membrane switch sheet but not where the electronic part has been installed, and providing on the spacer but not where the electronic part has been installed an upper membrane switch sheet the upper surface of which is at substantially the same level as the upper surface of the electronic part, and the upper membrane switch sheet carrying a printed circuit, part of which is opposed to the printed circuit on the lower membrane switch sheet to provide contact points for the membrane switch.

As a result, the membrane switch structure can be formed with a low height.

In the accompanying drawings:
FIG. 1 is explanatory drawing showing one example of a membrane switch sheet structure in accordance with the invention; and,
FIG. 2 is explanatory drawing of an example of the prior art.

As shown in FIG. 1, a membrane switch consists of two thin lower and upper plastic sheets 1,5 with a spacer 6 between them. The two sheets are made from polyester plastic film which has flexibility. Fixed wiring patterns 11, 51 are printed on the surfaces of the plastic sheets and provide electric contact points of the membrane switch. The three layer structure has a thickness of only 1.4mm.

In order to mount the electronic parts on the membrane switch sheet 1 and to connect the leads 21 of an electronic part 2 to the wiring pattern 11, non-conductive adhesive 3 is painted at the scheduled part of the membrane switch sheet 1 and conductive adhesive 4 is painted in the vicinity of the edge of the wiring pattern 11.

If the non-conductive adhesive 3 and the conductive adhesive 4 are made from thermosetting plastic materials such as an epoxy resin, the equipment cost for making the structure will be cheap.

Moreover, as the painting method there can be used the method of silk-printing or other printing method.

Next, the body of the chip diode 2 is contacted to the non-conductive adhesive 3, and the lead 21 of the chip diode 2 is touched to the conductive adhesive 4. Then, membrane switch 1 with the electronic part or parts thereon is put into a furnace, and heated.

The non-conductive adhesive 3 and conductive adhesive 4 are cured and stiffened by the heating. As a result, the body of the diode chip 2 fixed on the face of the membrane switch sheet 1 and the lead 21 is electrically and physically connected to the wiring pattern 11.

As shown, there is no covering material over the electronic parts, which would increase the thickness of the membrane switch. As shown in FIG. 1, the upper of the electronic part 2 is at about the same height as the upper surface 52 of the sheet 5. In addition, the non-conductive adhesive is stiffed by heating without using UV radiation.

In the above-mentioned embodiment, a flexible membrane switch sheet 1 was used for the wiring substrate. However, the present invention can be applied to a membrane switch with a rigid wiring substrate for example made from the epoxy-glass sheet, or the face of a board of a flexible flat cable.

The thermal stability of polyester resin is inferior to that of epoxy resin, but the curing temperature of epoxy resin is not so high.

## Claims

1. A membrane switch structure having an electronic part (2) fixed to a printed circuit (11), the structure comprising a lower membrane switch sheet (1), an upper membrane switch sheet (5) overlying the lower membrane switch sheet but not the electronic part (2); a spacer (6) between the lower and upper membrane switch sheets (1,5); and a printed circuit (11,51) on that surface of each of the lower and upper membrane switch sheets facing the other sheet, facing parts of the printed circuits providing electric contact points for the switch; the electronic part (2) being fixed onto the upper surface of the lower membrane switch sheet by means of an interposed painted layer (3) of non-conductive adhesive, and leads (21) of the electronic part being connected by means of a conductive adhesive (4) to the printed circuit on the lower membrane switch sheet (1) whereby the upper surface (22) of the electronic part is at substantially the same level as the upper surface (52) of the upper membrane switch sheet.

2. A method of manufacturing a membrane switch structure having an electronic part (2) fixed to a printed circuit (11), the method comprising the steps of forming a printed circuit on a lower membrane switch sheet (1); painting a non-conductive adhesive (3) on the lower membrane switch sheet where the electronic part is to be installed; applying a conductive adhesive (4) to a lead (21) of the electronic part and to the printed circuit and putting the electronic part on the lower membrane switch sheet where the part is to be installed, with the lead in contact with the printed circuit and the bottom of the electronic part in contact with the non conductive adhesive; curing the non-conductive and conductive adhesives by means of heat whereby the electronic part is installed on the lower membrane switch sheet with its lead connected to the printed circuit; providing a spacer (6) on the lower membrane switch sheet but not where the electronic part has been installed, and providing on the spacer but not where the electronic part has been installed an upper membrane switch sheet (5), the upper surface (52) of which is at substantially the same level as the upper surface (22) of the electronic part, and the upper membrane switch sheet carrying a printed circuit (51), part of which is facing the printed circuit on the lower membrane switch sheet to provide contact points for the membrane switch.

## Patentansprüche

1. Membranschalterstruktur mit einem elektronischen Bauteil (2), das an einer gedruckten Schaltung (11) befestigt ist, wobei die Struktur aufweist: ein unteres Membranschalter-Flächenelement (1), ein oberes Membranschalter-Flächenelement (5), das über dem unteren Membranschalter-Flächenelement liegt, jedoch nicht über dem elektronischen Bauteil (2); einen Abstandshalter (6) zwischen dem unteren und dem oberen Membranschalter-Flächenelement (1, 5) und eine gedruckte Schaltung (11, 51) auf derjenigen Oberfläche jeweils des unteren und des oberen Membranschalter-Flächenelements, die dem anderen Flächenelement zugekehrt ist, wobei einander zugekehrte Teile der gedruckten Schaltung elektrische Kontaktpunkte für den Schalter bilden; das elektronische Bauteil (2) auf der oberen Oberfläche des unteren Membranschalter-Flächenelements mittels einer dazwischen aufgetragenen Schicht (3) aus nichtleitendem Klebstoff befestigt ist und die Zuleitungen (21) des elektronischen Bauteils durch leitenden Klebstoff (4) mit der gedruckten Schaltung auf dem unteren Membranschalter-Flächenelement (1) verbunden sind, so daß die obere Oberfläche (22) des elektronischen Bauteils im wesentlichen in der gleichen Höhe wie die obere Oberfläche (52) des oberen Membranschalter-Flächenelements liegt.

2. Verfahren zum Herstellen einer Membranschalterstruktur mit einem elektronischen Bauteil (2), das an einer gedruckten Schaltung (11) befestigt ist, wobei das Verfahren umfaßt: das Ausbilden einer gedruckten Schaltung auf einem unteren Membranschalter-Flächenelement (1); das Auftragen eines nichtleitenden Klebstoffs (3) auf dem unteren Membranschalter-Flächenelement, wo das elektronische Bauteil angebracht werden soll; das Auftragen eines leitenden Klebstoffs (4) auf einer Zuleitung (21) des elektronischen Bauteils und der gedruckten Schaltung und das Anordnen des elektronischen Bauteils auf dem unteren Membranschalter-Flächenelement an der Stelle, wo das Bauteil angebracht werden soll, so daß die Zuleitung die gedruckte Schaltung kontaktiert und der Boden des elektronischen Bauteils den nichtleitenden Klebstoff berührt; das Aushärten des leitenden und des nichtleitenden Klebstoffs mittels Wärme, wobei das elektronische Bauteil auf dem unteren Membranschalter-Flächenelement so angebracht wird, daß seine Zuleitung mit der gedruckten Schaltung verbunden wird; das Anordnen eines Abstandshalters (6) auf dem unteren Membranschalter-Flächenelement, jedoch nicht dort, wo das elektronische Bauteil angeordnet ist, und das Anordnen eines oberen Membranschalter-Flächenelements (5) auf dem Abstandshalter, jedoch nicht dort, wo das elektronische Bauteil angebracht ist, so daß die obere Oberfläche (52) des oberen Membranschalter-Flächenelements sich etwa in gleicher Höhe wie die obere Oberfläche (22) des elektronischen Bauteils befindet und das obere Membranschalter-Flächenelement eine gedruckte Schaltung (51) trägt, von der ein Teil der gedruckten Schaltung auf dem unteren Membranschalter-Flächenelement zugekehrt ist, um Kontaktpunkte für den Membranschalter zu bilden.

## Revendications

1. Structure d'interrupteur à membrane comportant un composant électronique (2) fixé à un circuit imprimé (11), la structure comprenant une feuille inférieure d'interrupteur à membrane (1), une feuille supérieure d'interrupteur à membrane (5) recouvrant la feuille inférieure d'interrupteur à membrane mais ne recouvrant pas le composant électronique (2) ; une pièce d'écartement (6) entre les feuilles inférieure et supérieure d'interrupteur à membrane (1, 5) ; et un circuit imprimé (11, 51), sur la face de chacune dès feuilles inférieure et supérieure d'interrupteur à membrane qui fait face à l'autre feuille, faisant face aux parties des circuits imprimés fournissant des points de contact électrique pour l'interrupteur ; le composant électronique (2) étant fixé sur la face supérieure de la feuille inférieure d'interrupteur à membrane au moyen d'une couche intermédiaire badigeonnée de colle non conductrice(3), et les conducteurs (21) du composant électronique étant connectés, au moyen d'une colle conductrice (4), au circuit imprimé de la feuille inférieure d'interrupteur à membrane, ce par quoi la face supérieure (22) du composant électronique se trouve sensiblement au même niveau que la face supérieure (52) de la feuille supérieure d'interrupteur à membrane.

2. Procédé de fabrication d'une structure d'interrupteur à membrane comportant un composant électronique (2) fixé à un circuit imprimé (11), le procédé comprenant les étapes : de formation d'un circuit imprimé sur une feuille inférieure d'interrupteur à membrane (1) ; de badigeonnage, là où l'on doit installer le composant électronique, d'une colle non conductrice (3) sur la feuille inférieure d'interrupteur à membrane ; d'application d'une colle conductrice (4) sur un conducteur (21) du composant électronique et sur le circuit imprimé, et de placement du composant électronique sur la feuille inférieure d'interrupteur à membrane, là où l'on doit installer le composant, le conducteur étant en contact avec le circuit imprimé et la partie inférieure du composant électronique étant en contact avec la colle non conductrice ; de durcissement, au moyen de la chaleur, des colles non conductrice et conductrice, ce par quoi le composant électronique est installé sur la feuille inférieure d'interrupteur à membrane, son conducteur étant connecté au circuit imprimé ; de disposition d'une pièce d'écartement (6) sur la feuille inférieure d'interrupteur à membrane, sauf à l'emplacement où l'on a installé le composant électronique ; et de disposition sur la pièce d'écartement, sauf à l'emplacement où l'on a installé le composant électronique, d'une feuille supérieure d'interrupteur à membrane (5) dont la face supérieure (52) est sensiblement au même niveau que la face supérieure (22) du composant électronique, et la feuille supérieure d'interrupteur à membrane portant un circuit imprimé (51), dont une partie fait face au circuit imprimé de la feuille inférieure d'interrupteur à membrane pour fournir des points de contact pour l'interrupteur à membrane.
